# EUROPEAN PATENT SPECIFICATION

(11) **EP 1 771 603 B1**
(45) Date of publication and mention of the grant of the patent: **06.05.2015**
(21) Application number: 05757748.8
(22) Date of filing: 02.06.2005
(51) Int. Cl.: H05K 3/28

(54) **CORROSION RESISTANCE ENHANCEMENT OF TIN SURFACES**
VERBESSERUNG DER KORROSIONSBESTÄNDIGKEIT VON ZINNOBERFLÄCHEN
AUGMENTATION DE LA RESISTANCE A LA CORROSION DE SURFACES EN ETAIN

(30) Priority: 03.06.2004 US 860678
(43) Date of publication of application: 11.04.2007
(73) Proprietor: ENTHONE, INCORPORATED, West Haven, CT 06516 (US)
(72) Inventor: FAN, Chonglun, Jersey City, NJ 07304 (US); ABYS, Joseph A., West Haven, CT 06516 (US); XU, Chen, Jersey City, NJ 07304 (US); KUDRAK, Edward J. Jr., Jersey City, NJ 07304 (US); PANECCASIO, Vincent Jr., West Haven, CT 06516 (US); ZAVARINE, Igor, West Haven, CT 06516 (US); RIETMANN, Christian, D-407665 Sonsbeck (DE)
(74) Representative: Michalski Hüttermann & Partner Patentanwälte mbB
(86) International application number: PCT/US2005/019395
(87) International publication number: WO 2005/121405

(56) References cited:
- EP-A- 0 520 649
- WO-A-97/18905
- WO-A2-02/33145
- GB-A- 2 331 942
- US-A- 3 200 004
- US-A- 3 272 662
- US-A- 3 293 088
- US-A- 3 630 790
- US-A- 4 000 012
- US-A- 5 103 550
- US-A- 5 463 804
- US-A1- 2002 011 280

## Description

### FIELD OF THE INVENTION

This invention relates to methods and compositions for inhibiting corrosion of tin-based surfaces, and to inhibiting corrosion and enhancing solderability of such surfaces.

### BACKGROUND

Tin-based coatings are frequently applied to surfaces of copper- and nickel-based workpieces such as surfaces of electrical connectors, engineering, functional, and decorative devices in order to prevent the copper or nickel-based surface from oxidizing or tarnishing and/or to enhance solderability. Under conditions such as elevated temperatures in air or in other oxidizing atmospheres, tin-coated surfaces of electronic package leads and electrical connectors have a tendency to form oxide films during periods of shipment and storage between manufacture and assembly into electronic devices. The oxide coats, typically only about 50-200 Angstroms (Å) in thickness, discolor the surface of the tin-coated surface and impart a yellowish color which many consumers consider unacceptable. Furthermore, the oxide may degrade the contact resistance of a coated electrical terminal. A tarnish-free surface has lower electrical contact resistance and better solderability than an oxide coated surface.

U.S. Patent No. 3630790 discloses the protecting of metal surfaces, such as aluminum, tin, magnesium, iron, nickel, zinc and copper, against corrosion by contacting the metal surface with an aqueous solution of a phosphonic acid or sodium phosphonate and an organic solvent.

S. Chen, et al., in U.S. Patent No. 6,136,460 disclose approaches to reducing the oxidation of tin which involve inclusion of elements that have a more negative free energy of oxide formation than tin into the tin matrix. Such elements include potassium, sodium, calcium, chromium, manganese, magnesium, aluminum, vanadium, zinc, indium and phosphorus amongst several others. Such inclusion may be accomplished by electrolytic deposition of the element onto the tin surface, immersion of the surface in melts of the element, or immersion in salt solutions of the element followed by high temperature reflow techniques. The high temperature exposure renders the process unacceptable for certain temperature-sensitive applications, and increases processing time, cost, and equipment requirements.

GB Patent No. 2331942 discloses the protecting of metal surfaces, such as tin plate steel cold rolled steel, hot dip galvanized steel and galvanized steel, with 2 aqueous compositions of phosphonic acid, e.g., octylphosphonic acid, phosphonisuccinic acid, phosphonopropanoic acid, vinylphosphonic acid.

H.E. Fuchs, et al., in U.S. Patent No. 5,853,797 disclose a method and solution for providing corrosion protection of coated electrical contact surfaces which involve exposure of such surfaces to a solution containing phosphonates, lubricants and various volatile organic solvents. Evaporation of such solvents for disposal is fraught with environmental concerns such as handling, hazard to workers, and disposal of waste into streams.

The above approaches suffer from inherent disadvantages such as high processing temperatures, expense, and difficult solvents. Therefore, there is a need for a low temperature, environmentally friendly, and inexpensive method to provide an anti-tarnish, oxidation resistant, agent onto tin-based surfaces in order to provide protection against the yellowing and oxidation typically encountered by electrical terminals and connectors during storage and shipment. The present invention provides a solution to that need.

### SUMMARY OF THE INVENTION

Among the objects of the invention, therefore, is to provide a method and compositions for imparting corrosion resistance and enhancing solderability of a tin-based surface.

Briefly, therefore, the invention is directed to a method for enhancing corrosion resistance of a tin-based surface of a workpiece comprising contacting the tin-based surface with a composition as defined in claim 1 to form a phosphorus-based film over the tin-based coating thereby inhibiting corrosion of the tin-based surface.

The invention is also directed to various compositions for enhancing corrosion resistance of a tin-based surface on a workpiece comprising between about 0.01 and about 10 %w/v of a phosphonic acid compound; and waster; and up to about 5 vol. % of an alcohol as organic solvent.

Other objects and features of the invention are disclosed.

### BRIEF DESCRIPTION OF THE DRAWINGS

Figure 1 is a cross-section of a lead formed according to this invention for an encapsulated electronic component.
Figure 2 is an electronic packagage.
Figure 3 is a lead frame.
Figure 4 is an electrical connector.
Figures 5 and 6 are photographs of test pieces discussed in the examples.
Figure 7 is a graphical representation of test data of the examples.

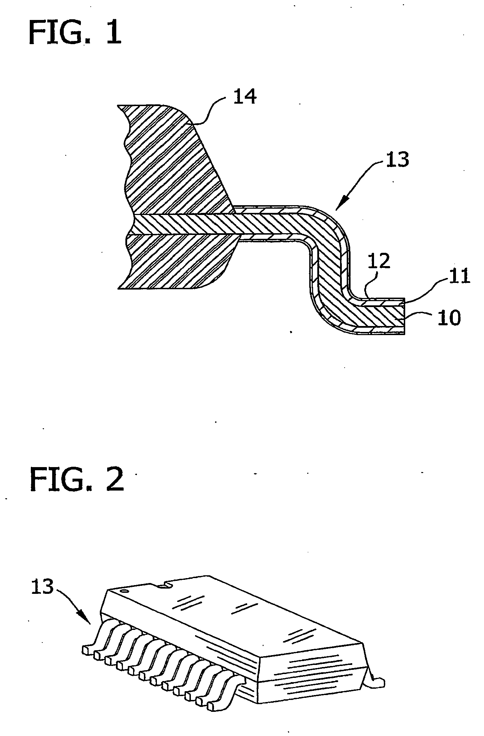

Figs 1-4 are schematic and are not drawn to scale.

Corresponding reference characters indicate corresponding parts throughout the drawings.

### DETAILED DESCRIPTION OF PREFERRED EMBODIMENTS

In one aspect the invention is directed to a method for enhancing corrosion resistance of a tin-based surface of a workpiece. For purposes of illustration, one such workpiece is an electronic component such as an electronic lead of an encapsulated electronic package, or is an electrical connector; but the invention is applicable to any tin-based surface whether part of an electronic device, engineering, functional, decorative, or otherwise. With regard to tin-based surfaces for electronic devices, the method enhances corrosion resistance and also preserves solderability of tin-based surfaces during storage prior to a soldering operation involving reflow of a portion of the tin-based surface.

In accordance with the invention, the tin-based surface is immersed or otherwise contacted with a composition as defined in claim 1 to form a phosphorus-based film over the tin-based surface. This film inhibits corrosion of the tin-based surface. The water is preferably deionized. The phosphonic acid compound has the formula: 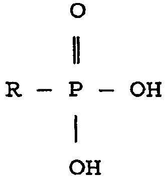 where R is hydrocarbyl or substituted hydrocarbyl and the H ions can be replaced by sodium or potassium to produce a phosphonate salt. In one embodiment, R⁻ is a long-chain linear or branched substituent and the H ions can be replaced by sodium or potassium to produce a phosphonate salt. In a preferred embodiment, the phosphonic acid compound is a phosphonic acid of the general formula CH₃(CH₂)ₙP(O)(OH)₂ wherein n is in the range 5 to 17. In one currently preferred embodiment, the composition contains octyl phosphonic acid as the phosphonic acid compound. It is believed that the PO₃⁻² moiety facilitates attachment of the compound to the substrate surface.

Unless otherwise indicated, the "substituted hydrocarbyl" moieties described herein are hydrocarbyl moieties which are substituted with at least one atom other than carbon, including moieties in which a carbon chain atom is substituted with a hetero atom such as nitrogen, oxygen, silicon, phosphorous, boron, sulfur, or a halogen atom. The hydrocarbyl moieties may be substituted with one or more of the following substituents: halogen, heterocyclo, alkoxy, alkenoxy, alkynoxy, aryloxy, hydroxy, protected hydroxy, hydroxycarbonyl, keto, acyl, acyloxy, nitro, amino, amido, nitro, phosphono, cyano, thiol, ketals, acetals, esters and ethers. Among the suitable compounds are, for example, decylphosphonic acid, octylphosphonic acid, vinylphosphonic acid, a petroleum naphtha (ZC-026) from Zip-Chem Products (Morgan Hill, California), and bifunctional molecules such as phosphonic acid compounds comprising carboxylic acid moieties.

In general, the range of concentration of the phosphonic acid compound is about 0.01 to 10 weight/volume percent (wt./vol.%)(1 wt./vol.% = 10 grams in 1 liter). Concentrations of less than 0.01 percent are not effective in corrosion protection, while concentrations above 10 weight percent tend to result in a material with too high a viscosity to be useful for most applications.

There are embodiments which consist essentially of these components, i.e., they contain no additional components which materially affect the basic properties of the invention. In the embodiments where components are specifically excluded, such exclusion is critical to achieving certain of the additional properties of those compositions, such as simplicity, low cost, predictability, reduction of risk of interactivity, and stability.

In the invention, organic solvents are employed to assist dissolving the phosphonic acid compound, but only to only a limited extent. In particular, the compositions of this embodiment contain no more than about 30% ethanol as organic solvent by volume (vol.%), and in some embodiments, less than about 5% alcohol as organic solvent by volume. By keeping the concentration of such organic solvents at a low level, concerns such as handling, hazard to workers, disposal of waste into streams, flash point, and expense are substantially reduced.

The invention is also directed to concentrates containing much less water, which are to be diluted prior to use.

In performing the method of the invention, tin-based surfaces to be treated are exposed to the composition of the invention by immersion, cascading, spraying, or brushing. The exposure time in one embodiment is between about 1 sec and about 60 sec. The temperature of the composition is between about 20 C and about 45 C. The treated surfaces are normally not rinsed. In some cases, the surface may be rinsed to increase the brightness of the surface. However, this rinse can reduce the effectiveness of the film because it partially removes it. The composition is allowed to air dry on the surface to leave a thin phosphorus-based film estimated to be between about 5 Å and about 10000 Å thick.

After drying, the components are stored and/or shipped to a subsequent manufacturing operation where they are incorporated into an electronic device by a metals joining technique, i.e., soldering. Exposure of the treated surfaces to temperatures above about 230°C are specifically avoided between deposition of the film and such time as an actual manufacturing operation. In the manufacturing operation the tin surface is reflowed at a temperature above about 230°C as part of an assembly operation involving connection of the surfaces to a substrate of a device. Accordingly, the first exposure of the phosphorus film-bearing tin-based surface to a temperature above about 230°C is a joining operation.

In one aspect, the method of the invention involves a lead 13 (Figure 1), which is a segment of any standard electronic package employing leads, e.g., the package displayed in Figure 2.

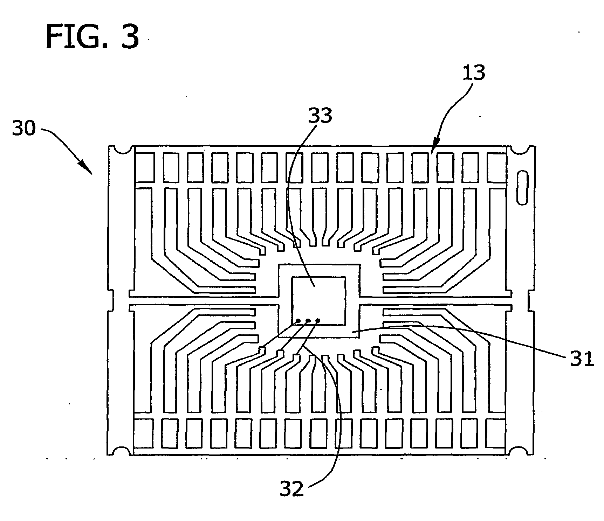

Figure 1 shows a cross section of part of an electronic package 14 with a lead 13 having a conductive base metal 10, and a tin or tin alloy coating 11. The base metal may be copper, a copper alloy, iron, an iron alloy, or any other metal suitable for use in electronic components. A tin or tin alloy coating is applied to provide corrosion resistance and solderability to the metal feature. Examples of tin alloys employed include Sn-Bi, Sn-Cu, and Sn-Ag. The Sn coating 11 is typically applied to the exposed lead line 10 after application of encapsulation 14. Optionally, however, the Sn coating is applied earlier in the process, i.e., to the lead frame 30 shown in Figure 3.

An electronic package of the type treated in accordance with one embodiment of the invention is manufactured in part from a lead frame 30 shown in Figure 3. An electronic device 33 is positioned on a pad 31 and connected to leads 13 by wire bonds 32, prior to an encapsulation step which yields the package 14 in Figure 1.

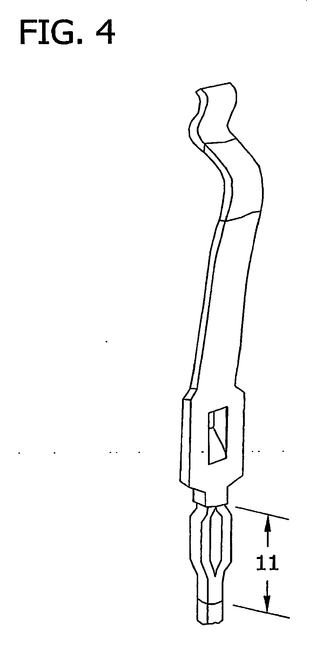

In another aspect, this invention encompasses an electronic connector as shown in Figure 4. The Sn coating is typically applied to the exposed segment 11, and in accordance with the invention this is contacted with the phosphorus-containing composition of the invention.

These figures are schematic and the various respective layers are not drawn to scale.

Further details of the invention are given in the following examples.

### EXAMPLE 1

Copper sheets having a tin-based surface thereon were immersed in three distinct compositions of the invention in a balance of deionized water for about 10 seconds:
A - 1.2 wt/vol% octylphosphonic acid; 22 vol% ethanol
AA - 1.6 wt/vol% octylphosphonic acid; 0.2 vol% ethanol
AAA - 1.6 wt/vol% octylphosphonic acid; 0% ethanol (comparative)

These sheets, and a copper sheet with a tin-based surface thereon with no phosphorus-based composition treatment according to the invention, were exposed to steam aging under the conditions of 85°C and 85% relative humidity (RH). The samples were thereafter observed for discoloration (yellowish color) as follows, where X is the number of days until first observation of discoloration was made:

**Table 1. Discoloration test results on tin coatings.**

| Post-treatment | Days |
|---|---|
| No treatment | 0 < X ≤ 2 |
| A | 88 < X ≤ 106 |
| AA | 73 < X ≤ 91 |
| AAA (comparative) | 73 < X ≤ 91 |

These results illustrate that with the method and compositions of the invention A, AA, there was no noticeable discoloration even after two months.

### EXAMPLE 2

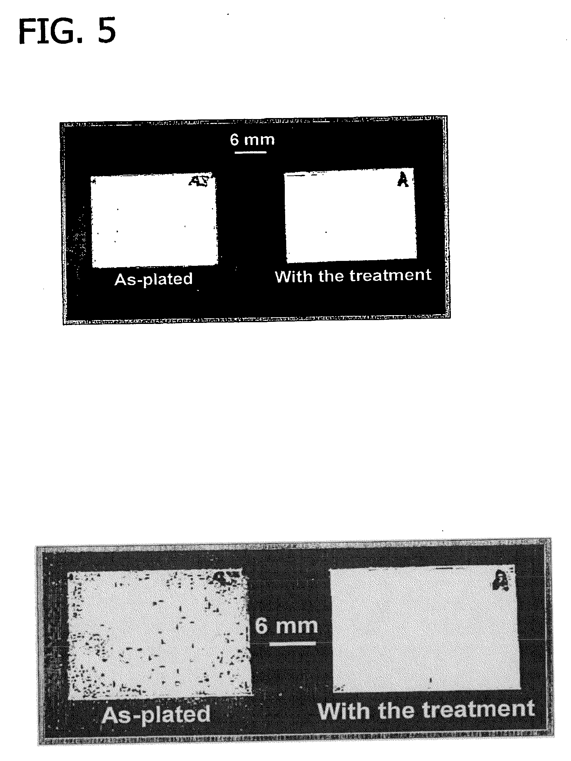

Photographs were taken of the as-plated copper sheet without the treatment of the invention, and of the copper sheet receiving the treatment of the invention with composition A by immersion for about 10 seconds. Photographs taken after 23 days of 85°C/85% RH steam aging are presented in Fig. 5. These illustrate discoloration in the as-plated sample and no discoloration in the sample treated according to the invention.

### EXAMPLE 3

Photographs were taken of the as-plated copper sheet without the treatment of the invention, and of the copper sheet receiving the treatment of the invention with composition A by immersion for 10 seconds. Photographs taken after 106 days of 85°C/85% RH steam aging are presented in Fig. 6. These illustrate severe corrosion in the as-plated sample and only minor discoloration at the edges in.the sample treated according to the invention.

### EXAMPLE 4

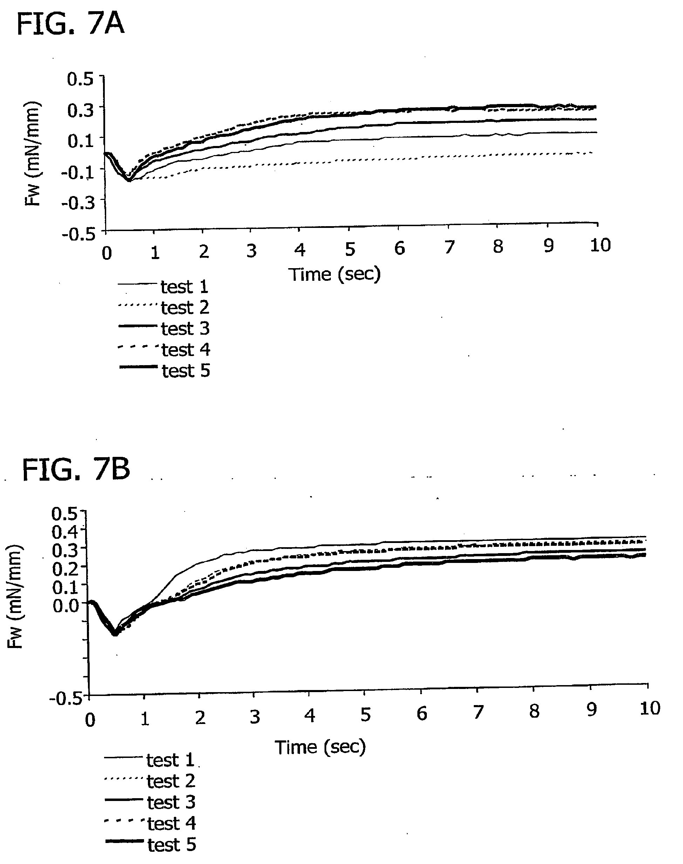

Tin-plated samples having undergone steam aging for 18 hours under the conditions of 85°C and 85% relative humidity were subjected to solderability wetting balance tests (Joint Industry Standard J-STD-002). The wetting balance test conditions were: Sn63Pb37 solder, 235 C, R-type non-activated flux. The results of five tests conducted on as-plated samples not receiving the treatment of the invention are presented in Fig. 7A. These results reveal a broad deviation of readings, and long wetting times (average zero cross time, ZCT > 3.40 sec).

The results of five tests conducted on samples receiving the treatment of the invention (1.6 wt/vol% octylphosphonic acid in water and 0.2% ethanol) are presented in Fig. 7B. These results reveal that oxidation of the tin-based surface was alleviated. The samples provided relatively low wetting time readings (average ZCT = 1.36 ± 0.12 sec) and a narrow deviation of the readings after the steam aging. Treatment with the corrosion inhibiting material therefore significantly improved the wettability and solderability of the tin-based surfaces.

The present invention is not limited to the above embodiments and can be variously modified. The above description of preferred embodiments is intended only to acquaint others skilled in the art with the invention, its principles and its practical application so that others skilled in the art may adapt and apply the invention in its numerous forms, as may be best suited to the requirements of a particular use.

With reference to the use of the word(s) "comprise" or "comprises" or "comprising" in this entire specification (including the claims below), it is noted that unless the context requires otherwise, those words are used on the basis and clear understanding that they are to be interpreted inclusively, rather than exclusively, and that it is intended each of those words to be so interpreted in construing this entire specification.

## Claims

1. A method for enhancing corrosion resistance of a tin-based surface on a workpiece comprising:
contacting the tin-based surface with a composition comprising a phosphonic acid compound and water to form a phosphorus-based film over the tin-based surface;
wherein the composition further comprises an alcohol as an organic solvent in a concentration of less than about 5 vol. % of the composition or ethanol as an organic solvent in a concentration less than about 30 vol. % of the composition.

2. The method of claim 1 wherein the composition comprises:
the phosphonic acid compound;
the alcohol as the organic solvent in the concentration less than about 5 vol. % of the composition; and
the water.

3. The method of claim 1 wherein the composition comprises:
the phosphonic acid compound;
the ethanol as the organic solvent in the concentration less than about 30 vol. % of the composition: and
the water.

4. The method of claim 1 wherein the composition comprises:
the phosphonic acid compound;
the ethanol as the organic solvent in the concentration less than about 5 vol. % of the composition; and
the water.

5. The method of any one of the claims 2 through 4 wherein the phosphonic acid compound constitutes between about 0.01 and about 10 weight/volume %.

6. The method of any one of claims 2 through 5 wherein the phosphonic acid compound has a structure of the following formula: 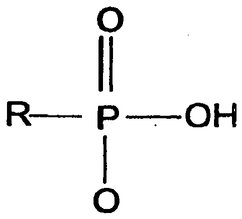 where R is hydrocarbyl or substituted hydrocarbyl and the H ions can be replaced by sodium or potassium to produce a phosphonate salt.

7. The method of any one of claims 2 through 5 wherein the phosphonic acid compound has a structure of the following formula: 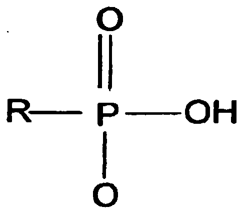 Where R is a long-chain linear or branched substituent and the H ions can be replaced by sodium or potassium to produce a phosphonate salt.

8. The method of any one of claims 2 through 5 wherein the phosphonic acid compound has the general formula CH₃(CH₂)ₙP(O)(OH)₂ wherein n is in the range of 5-17.

9. The method of any one of claims 2 through 5 wherein the phosphonic acid compound is octylphosphonic acid.

10. The method of any one of claims 2 through 4 wherein the composition consists essentially of the phosphonic acid compound in a concentration between about 0.01 and 10 weight/volume %, the organic solvent and the water.

11. The method of any one of claims 1 through 5 or 10 wherein the phosphonic acid compound is selected from the group consisting of decyclophosphonic acid, vinylphosphonic acid, and phosphonic acid compounds comprising carboxylic acid moieties.

12. The method of any one of claims 1 through 5 or 10 wherein the phosphonic acid compound comprises bifunctional molecules.

13. The method of claim 6 wherein R is the substituted hydrocarbyl and is substituted with at least one atom other than carbon selected from the group consisting of nitrogen, oxygen, silicon, phosphorus, boron, sulfur, and a halogen atom.

14. The method of claim 6 wherein R is the substituted hydrocarbyl and is substituted with a substituent selected from the group consisting of halogen, heterocyclo, alkoxy, alkenoxy, alkynoxy, aryloxy, hydroxy, protected hydroxy, hydroxycarbonyl, keto, acyl, acyloxy, nitro, amino, amido, phosphono, cyano, thiol, ketals, acetals, esters, and ethers.

15. Method of any one of claims 2 through 12 wherein the workpiece is an electronic component with the tin-based surface thereon, and the method comprises contacting the tin-based surface on the electronic component with the composition comprising the phosphonic acid compound and the water to form the phosphorus-based film over the tin-based surface thereby inhibiting corrosion of the tin-based surface

16. The method of any one of claims 2 through 12 wherein the workpiece is an electronic component with the tin-based surface thereon for providing a solderable surface in a soldering operation, and the method comprises contacting the tin-based surface on the electronic component with the composition comprising the phosphonic acid compound and the water to form the phosphorus-based film over the tin-based surface and preserving solderability of the tin-based coating on the electronic component during storage prior to soldering operation involving reflow of a portion of the tin-based surface.

17. A composition for enhancing corrosion resistance of a tin-based surface on a workpiece consisting essentially of:
a concentration between about 0.01 and about 10 weight/volume % of a phosphonic acid compound of the formula: 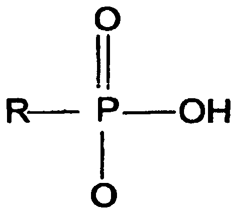 where R is hydrocarbyl or substituted hydrocarbyl and the H ions can be replaced by sodium or potassium to produce a phosphonate salt;
a concentration up to about 5 vol. % of an alcohol as organic solvent.
and water.

18. The composition of claim 17 wherein the phosphonic acid compound has the general formula CH₃(CH₂)ₙP(O)(OH)₂ wherein n is in the range of 5-17.

19. The composition of claim 17 wherein the phosphonic acid compound is octylphosphonic acid.

20. The composition of claim 17 wherein the phosphonic acid compound is selected from the group consisting of decyclophosphonic acid, vinylphosphonic acid, and phosphonic acid compounds comprising carboxylic acid moieties.

21. The composition of claim 17 wherein the phosphonic acid compound comprises bifunctional molecules.

22. The composition of claim 17 wherein R is the substituted hydrocarbyl and is substituted with at least one atom other than carbon selected from the group consisting of nitrogen, oxygen, silicon, phosphorus, boron, sulfur, and a halogen atom.

23. The composition of claim 17 wherein R is the substituted hydrocarbyl and is substituted with a substituent selected from the group consisting of halogen, heterocyclo, alkoxy, alkenoxy, alkynoxy, aryloxy, hydroxy, protected hydroxy, hydroxycarbonyl, keto, acyl, acyloxy, nitro, amino, amido, phosphono, cyano, thiol, ketals, acetals, esters, and ethers.

## Patentansprüche

1. Verfahren zum Erhöhen der Korrosionsbeständigkeit einer Oberfläche auf Zinnbasis auf einem Werkstück, mit den Schritten:
Inkontaktbringen der Oberfläche auf Zinnbasis mit einer Zusammensetzung, die eine Phosphonsäureverbindung und Wasser enthält, zum Ausbilden einer Schicht auf Phosphorbasis auf der Oberfläche auf Zinnbasis, wobei die Zusammensetzung ferner einen Alkohol als ein organisches Lösungsmittel in einer Konzentration von weniger als etwa 5 Vol.-% oder Ethanol als ein organisches Lösungsmittel in einer Konzentration von weniger als etwa 30 Vol.-% der Zusammensetzung aufweist.

2. Verfahren nach Anspruch 1, wobei die Zusammensetzung aufweist:
die Phosphonsäureverbindung;
den Alkohol als das organische Lösungsmittel in der Konzentration von weniger als etwa 5 Vol.-% der Zusammensetzung; und
das Wasser.

3. Verfahren nach Anspruch 1, wobei die Zusammensetzung aufweist:
die Phosphonsäureverbindung;
das Ethanol als das organische Lösungsmittel in der Konzentration von weniger als etwa 30 Vol.-% der Zusammensetzung; und
das Wasser.

4. Verfahren nach Anspruch 1, wobei die Zusammensetzung aufweist:
die Phosphonsäureverbindung;
das Ethanol als das organische Lösungsmittel in der Konzentration von weniger als etwa 5 Vol.-% der Zusammensetzung; und
das Wasser.

5. Verfahren nach einem der Ansprüche 2 bis 4, wobei die Phosphonsäureverbindung zwischen etwa 0,01 und etwa 10 % (w/v) bildet.

6. Verfahren nach einem der Ansprüche 2 bis 5, wobei die Phosphonsäureverbindung eine Struktur mit der folgenden Formel hat: 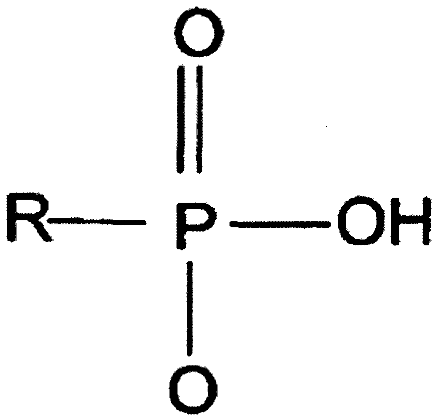 wobei R Hydrocarbyl oder substituiertes Hydrocarbyl ist und die H-Ionen durch Natrium oder Kalium ersetzbar sind, um ein Phosphonatsalz zu erzeugen.

7. Verfahren nach einem der Ansprüche 2 bis 5, wobei die Phosphonsäureverbindung eine Struktur mit der folgenden Formel hat: 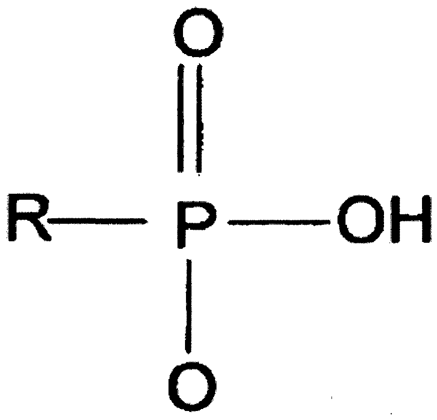 wobei R ein langkettiger linearer oder verzweigter Substituent ist und die H-lonen durch Natrium oder Kalium ersetzbar sind, um ein Phosphonatsalz zu erzeugen.

8. Verfahren nach einem der Ansprüche 2 bis 5, wobei die Phosphonsäureverbindung die allgemeine Formel CH₃(CH₂)ₙP(O)(OH)₂ hat, wobei n im Bereich von 5 - 17 liegt.

9. Verfahren nach einem der Ansprüche 2 bis 5, wobei die Phosphonsäureverbindung Octylphosphonsäure ist.

10. Verfahren nach einem der Ansprüche 2 bis 4, wobei die Zusammensetzung im Wesentlichen aus der Phosphonsäureverbindung in einer Konzentration zwischen etwa 0,01 und 10 % (w/v), dem organischen Lösungsmittel und dem Wasser besteht.

11. Verfahren nach einem der Ansprüche 1 bis 5 oder 10, wobei die Phosphonsäureverbindung aus der Gruppe bestehend aus Decyclophosphonsäure, Vinylphosphonsäure und Phosphonsäureverbindungen besteht, die funktionelle Carbonsäuregruppen enthalten.

12. Verfahren nach einem der Ansprüche 1 bis 5 oder 10, wobei die Phosphonsäureverbindung bifunktionelle Moleküle enthält.

13. Verfahren nach Anspruch 6, wobei R das substituierte Hydrocarbyl ist und durch mindestens ein von Kohlenstoff verschiedenes Atom substituiert ist, das aus der Gruppe bestehend aus Stickstoff, Sauerstoff, Silizium, Phosphor, Bor, Schwefel und einem Halogenatom ausgewählt ist.

14. Verfahren nach Anspruch 6, wobei R das substituierte Hydrocarbyl ist und durch einen Substituenten substituiert ist, der aus der Gruppe bestehend aus einem Halogen, einem Heterozyklus, einem Alkoxy, einem Alkenoxy, einem Alkynoxy, einem Acryloxy, einem Hydroxy, einem geschützten Hydroxy, Hydroxycarbonyl, einem Keto, einem Acyl, einem Acyloxy, einem Nitro, einem Amino, einem Amido, einem Phosphono, einem Cyano, einem Thiol, Ketalen, Acetalen, Estern und Ethern ausgewählt ist.

15. Verfahren nach einem der Ansprüche 2 bis 12, wobei das Werkstück ein elektronisches Bauelement mit der darauf ausgebildeten Oberfläche auf Zinnbasis ist, und wobei das Verfahren das Inkontaktbringen der Oberfläche auf Zinnbasis auf dem elektronischen Bauelement mit der Zusammensetzung aufweist, die die Phosphonsäureverbindung und das Wasser aufweist, um die Schicht auf Phosphorbasis auf der Oberfläche auf Zinnbasis auszubilden und so Korrosion der Oberfläche auf Zinnbasis zu verhindern.

16. Verfahren nach einem der Ansprüche 2 bis 12, wobei das Werkstück ein elektronisches Bauelement mit der darauf ausgebildeten Oberfläche auf Zinnbasis ist, um eine lötbare Oberfläche für einen Lötvorgang bereitzustellen, und wobei das Verfahren das Inkontaktbringen der Oberfläche auf Zinnbasis auf dem elektronischen Bauelement mit der Zusammensetzung aufweist, die die Phosphonsäureverbindung und das Wasser aufweist, um die Schicht auf Phosphorbasis auf der Oberfläche auf Zinnbasis auszubilden und so die Lötbarkeit der Schicht auf Zinnbasis auf dem elektronischen Bauelement während einer Lagerung vor einem Lötvorgang aufrechtzuerhalten, der das Wiederaufschmelzen eines Teils der Oberfläche auf Zinnbasis beinhaltet.

17. Zusammensetzung zum Erhöhen der Korrosionsbeständigkeit einer Oberfläche auf Zinnbasis auf einem Werkstück, wobei die Zusammensetzung im Wesentlichen aus
einer Konzentration zwischen etwa 0,01 und etwa 10 % (w/v) einer Phosphonsäureverbindung mit der Formel 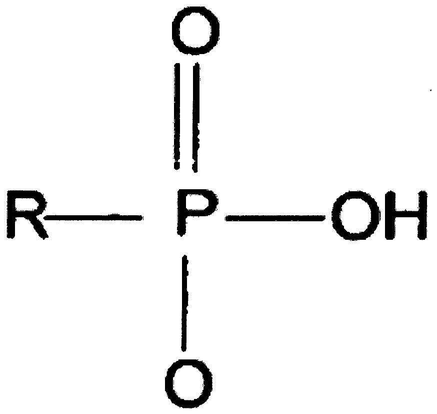 besteht, wobei R Hydrocarbyl oder substituiertes Hydrocarbyl ist und die H-Ionen durch Natrium oder Kalium ersetzbar sind, um ein Phosphonatsalz zu erzeugen;
Alkohol als ein organisches Lösungsmittel in einer Konzentration bis zu etwa 5 Vol.-%; und
Wasser.

18. Zusammensetzung nach Anspruch 17, wobei die Phosphonsäureverbindung die allgemeine Formel CH₃(CH₂)ₙP(O)(OH)₂ hat, wobei n im Bereich von 5 - 17 liegt.

19. Zusammensetzung nach einem der Ansprüche 17, wobei die Phosphonsäureverbindung Octylphosphonsäure ist.

20. Zusammensetzung nach Anspruch 17, wobei die Phosphonsäureverbindung aus der Gruppe bestehend aus Decyclophosphonsäurem Vinylphosphonsäure und Phosphonsäureverbindungen ausgewählt wird, die funktionelle Carbonsäuregruppen enthalten.

21. Zusammensetzung nach Anspruch 17, wobei die Phosphonsäureverbindung bifunktionelle Moleküle enthält.

22. Zusammensetzung nach Anspruch 17, wobei R das substituierte Hydrocarbyl ist und durch mindestens ein von Kohlenstoff verschiedenes Atom substituiert ist, das aus der Gruppe bestehend aus Stickstoff, Sauerstoff, Silizium, Phosphor, Bor, Schwefel und einem Halogenatom ausgewählt ist.

23. Zusammensetzung nach Anspruch 17, wobei R das substituierte Hydrocarbyl ist und durch einen Substituenten substituiert ist, der aus der Gruppe bestehend aus einem Halogen, einem Heterozyklus, einem Alkoxy, einem Alkenoxy, einem Alkynoxy, einem Acryloxy, einem Hydroxy, einem geschützten Hydroxy, Hydroxycarbonyl, einem Keto, einem Acyl, einem Acyloxy, einem Nitro, einem Amino, einem Amido, einem Phosphono, einem Cyano, einem Thiol, Ketalen, Acetalen, Estern und Ethern ausgewählt ist.

## Revendications

1. Procédé d'amélioration de la résistance à la corrosion d'une surface à base d'étain sur une pièce comprenant :
la mise en contact de la surface à base d'étain avec une composition comprenant un composé d'acide phosphonique et de l'eau afin de former un film à base de phosphore au dessus de la surface à base d'étain ;
où la composition comprend en outre un alcool servant de solvant organique à une concentration inférieure à environ 5 % en volumes de la composition, ou de l'éthanol servant de solvant organique à une concentration inférieure à environ 30 % en volumes de la composition.

2. Procédé selon la revendication 1, dans lequel la composition comprend :
le composé d'acide phosphonique ;
l'alcool servant de solvant organique à la concentration inférieure à environ 5 % en volume de la composition ; et
l'eau.

3. Procédé selon la revendication 1, dans lequel la composition comprend :
le composé d'acide phosphonique ;
l'éthanol servant de solvant organique à une concentration inférieure à environ 30 % en volumes de la composition ; et
l'eau.

4. Procédé selon la revendication 1, dans lequel la composition comprend :
le composé d'acide phosphonique ;
l'éthanol servant de solvant organique à une concentration inférieure à environ 5 % en volumes de la composition ; et
l'eau.

5. Procédé selon l'une quelconque des revendications 2 à 4, dans lequel le composé d'acide phosphonique constitue entre environ 0,01 et environ 10 % du poids par rapport au volume.

6. Procédé selon l'une quelconque des revendications 2 à 5, dans lequel le composé d'acide phosphonique possède une structure de la formule suivante : 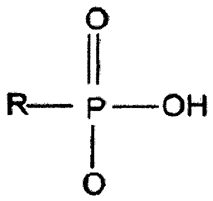 où R est un groupe hydrocarbyle ou un groupe hydrocarbyle substitué et les ions H peuvent être remplacés par des ions sodium ou potassium pour produire un sel phosphonate.

7. Procédé de l'une quelconque des revendications 2 à 5, dans lequel le composé d'acide phosphonique possède une structure de la formule suivante : 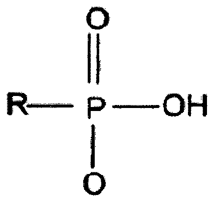 où R est un substituant linéaire à longue chaîne ou branché et les ions H peuvent être remplacés par des ions sodium ou potassium pour produire un sel phosphonate.

8. Procédé selon l'une quelconque des revendications 2 à 5, dans lequel le composé d'acide phosphonique possède la formule générale CH₃(CH₂)ₙP(OXOH)₂ où n est un nombre de l'intervalle 5 à 17.

9. Procédé selon l'une quelconque des revendications 2 à 5, dans lequel le composé d'acide phosphonique est de l'acide octylphosphonique.

10. Procédé selon l'une quelconque des revendications 2 à 4, dans lequel la composition consiste essentiellement en le composé d'acide phosphonique à une concentration entre environ 0,01 et 10 % en poids par rapport au volume, en solvant organique et en eau.

11. Procédé selon l'une quelconque des revendications 1 à 5 ou 10, dans lequel le composé d'acide phosphonique est choisi dans le groupe constitué de composés d'acide décyclophosphonique, d'acide vinylphosphonique, et de composés d'acide phosphonique comprenant des groupements acide carboxylique.

12. Procédé selon l'une quelconque des revendications 1 à 5 ou 10, dans lequel le composé d'acide phosphonique comprend des molécules bifonctionnelles.

13. Procédé selon la revendication 6, dans lequel R est un groupe hydrocarbyle substitué et est substitué avec au moins un atome autre que du carbone choisi dans le groupe constitué par un atome d'azote, d'oxygène, de silicium, de phosphore, de bore, de soufre et d'halogène.

14. Procédé selon la revendication 6, dans lequel R est un groupe hydrocarbyle substitué et est substitué avec un substituant choisi dans le groupe constitué par un halogène, un groupe hétérocyclo, un groupe alcoxy, un groupe alcénoxy, un groupe alcynoxy, un groupe aryloxy, un groupe hydroxy, un groupe hydroxy protégé, un groupe hydroxycarbonyle, un groupe cétone, un groupe acyle, un groupe acyloxy, un groupe nitro, un groupe amino, un groupe amido, un groupe phosphono, un groupe cyano, un groupe thiol, des groupes cétal, des groupe acétal, des groupes ester et des groupes éther.

15. Procédé selon l'une quelconque des revendications 2 à 12, dans lequel la pièce est un composant électronique avec la surface à base d'étain sur le dessus, et le procédé comprend la mise en contact de la surface à base d'étain sur le composant électronique avec la composition comprenant le composé d'acide phosphonique et l'eau afin de former un film à base de phosphore au dessus de la surface à base d'étain, inhibant par ce moyen la corrosion de la surface à base d'étain.

16. Procédé selon l'une quelconque des revendications 2 à 12, dans lequel la pièce est un composant électronique avec la surface à base d'étain sur le dessus afin de procurer une surface soudable dans une opération de soudure, et le procédé comprend la mise en contact de la surface à base d'étain sur le composant électronique avec la composition comprenant le composé d'acide phosphonique et l'eau afin de former un film à base de phosphore au dessus de la surface à base d'étain et en préservant la soudabilité du revêtement à base d'étain sur le composant électronique durant le stockage avant l'opération de soudure en mettant en oeuvre une refusion d'une partie de la surface à base d'étain.

17. Composition, destinée à augmenter la résistance à la corrosion d'une surface à base d'étain sur une pièce, constituée essentiellement :
d'une concentration entre environ 0,01 et environ 10 % en poids par rapport au volume d'un composé d'acide phosphonique de formule : 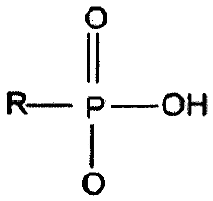 où R est un groupe hydrocarbyle ou hydrocarbyle substitué et les ions H peuvent être remplacés par des ions sodium ou potassium afin de produire un sel phosphonate ;
une concentration jusqu'à environ 5 % en volume d'un alcool servant de solvant organique.

18. Composition selon la revendication 17, dans laquelle le composé d'acide phosphonique possède une formule générale CH₃(CH₂)ₙP(OXOH)₂ où n est un nombre de l'intervalle 5 à 17.

19. Composition selon la revendication 17, dans laquelle le composé d'acide phosphonique est l'acide octylphosphonique.

20. Composition selon la revendication 17, dans laquelle le composé d'acide phosphonique est choisi dans le groupe constitué par l'acide décyclophosphonique, l'acide vinylphosphonique et des composés d'acide phosphonique comprenant des groupements acide carboxylique.

21. Composition selon la revendication 17, dans laquelle le composé d'acide phosphonique comprend des molécules bifonctionnelles.

22. Composition selon la revendication 17, dans laquelle R est le groupe hydrocarbyle substitué et est substitué avec au moins un atome autre que du carbone choisi dans le groupe constitué des atomes d'azote, d'oxygène, de silicium, de phosphore, de bore, de soufre et d'halogène.

23. Composition selon la revendication 17, dans laquelle R est le groupe hydrocarbyle substitué et est substitué avec un substituant choisi dans le groupe constitué par les groupes halogène, hétérocyclo, alcoxy, alcénoxy, alcynoxy, aryloxy, hydroxy, hydroxy protégé, hydroxycarbonyle, cétone, acyle, acyloxy, nitro, amino, amido, phosphono, cyano, thiol, cétals, acétals, esters, et éthers.
